(19) Europäisches Patentamt

European Patent Office

Office européen des brevets

(11) Veröffentlichungsnummer: **0 206 261 B1**

(12) **EUROPÄISCHE PATENTSCHRIFT**

(45) Veröffentlichungstag der Patentschrift: **12.08.92**

(51) Int. Cl.⁵: **G03F  7/16**

(21) Anmeldenummer: **86108378.0**

(22) Anmeldetag: **19.06.86**

(54) **Verfahren zur Herstellung einer strahlungsempfindlichen Schicht auf einem Schichtträger.**

(30) Priorität: **28.06.85 DE 3523176**

(43) Veröffentlichungstag der Anmeldung:
**30.12.86 Patentblatt  86/52**

(45) Bekanntmachung des Hinweises auf die
Patenterteilung:
**12.08.92 Patentblatt  92/33**

(84) Benannte Vertragsstaaten:
**BE CH DE FR GB IT LI NL SE**

(56) Entgegenhaltungen:
**EP-A- 0 078 981        DE-A- 1 809 248**
**DE-A- 2 364 631        DE-A- 2 407 089**
**DE-A- 2 914 558        FR-A- 1 528 185**

(73) Patentinhaber: **HOECHST AKTIENGESELL-
SCHAFT
Postfach 80 03 20
W-6230 Frankfurt am Main 80(DE)**

(72) Erfinder: **Hultzsch, Günther, Dr. Dipl.-Chem.
Drususstrasse 61
W-6200 Wiesbaden(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Herstellung einer strahlungsempfindlichen Resistschicht auf einem Schichtträger bei dem man eine strahlungsempfindliche Beschichtungslösung, die als wesentliche Bestandteile eine strahlungsempfindliche Verbindung, eine strahlungsempfindliche Kombination von Verbindungen oder eine photoleitfähige Verbindung, gelöst in einem organischen Lösemittel oder Lösemittelgemisch enthält, durch elektrostatische Sprühbeschichtung auf den Schichtträger aufbringt und trocknet.

Die bekannten Beschichtungsverfahren (Tauchziehen, Roller-coating, Vorhanggießen) für den Antrag strahlungsempfindlicher Schichten, insbesondere Photoresistschichten, haben bestimmte Nachteile dadurch, daß die Beschichtungslösung im Kreisverlauf gefahren und damit großer Aufwand bei der Viskositätsregelung und Filtration getrieben werden muß. Diese Verfahren erfordern ferner hohen Aufwand zur Reinigung und Wartung der Beschichtungsanlagen. Außerdem kann bei diesen Verfahren die Stärke des Auftrags meist nur durch Änderung des Feststoffgehaltes bzw. der Viskosität der Lösung geregelt werden. Bei anderen Beschichtungsverfahren, wie Schleudern (spin-coating) oder Sprühbeschichten mittels Druckluft, werden zwar stets frische Beschichtungslösungen eingesetzt, so daß die Viskosität konstant bleibt und der Lack nicht filtriert werden muß, jedoch gelangen bei diesen Verfahren nur bis zu 55 % der Lösung auf den Schichtträger. Der Rest geht für die Beschichtung verloren.

Die Sprühlackierung mittels elektrostatischer Verfahren dient zur Oberflächenveredelung metallischer oder elektrisch leitfähiger Werkstücke und wird großindustriell eingesetzt. Beim Sprühantrag werden üblicherweise Lacke in Schichtdicken von wenigstens 20 $\mu$m angetragen. Um höhere Schichtdicken zu erhalten, werden möglichst festkörperreiche Lacke eingesetzt. Die verwendeten Lösemittel besitzen hohe Verdampfungstemperaturen und niedrige Verdampfungsgeschwindigkeiten. Zur Trocknung und Härtung werden Einbrenntemperaturen von oft weit über 140 °C angewendet.

Strahlungsempfindliche Beschichtungslösungen, insbesondere Photoresistlösungen, enthalten im allgemeinen strahlungsempfindliche Komponenten und Bindemittel sowie gegebenenfalls weitere Zusätze oder Hilfsmittel. Zur Anfärbung dienen in der Regel gelöste Farbstoffe. Die strahlungsempfindlichen Verbindungen besitzen überwiegend stark polaren Charakter und müssen daher in entsprechend polaren Lösemitteln gelöst werden. Geeignet sind z. B. Ester, Ketone oder Alkohole. Die strahlungsempfindlichen Substanzen sind in der Regel auch wärmeempfindlich; daher müssen überwiegend Trocknungstemperaturen von weniger als 100 °C angewandt werden. Derartige Lösungen, z. B. Ätzresistlösungen zur Herstellung von Leiterplatten, werden daher bevorzugt in flüchtigen und polaren Lösemitteln hergestellt. Zur Verbesserung der Verlaufeigenschaften dient häufig ein Gemisch verschiedener Lösemittel.

Die Lichtempfindlichkeit der strahlungsempfindlichen Beschichtung ist umso höher, je geringer die Schichtdicke ist. Ziel ist es daher, Schichten nur so dünn anzutragen, wie es für deren Funktion, z. B. als Ätzresist, erforderlich ist. Dieser Bereich liegt im allgemeinen zwischen 1 und 10 $\mu$m.

In der Elektronikindustrie interessiert ein Beschichtungsverfahren, bei dem die Resistlösung nicht ständig umgepumpt und filtriert werden muß, die Lackausbeute gleichzeitig hoch ist und die Schichtstärke variiert werden kann. Ferner sollte der Wartungs- und Reinigungsaufwand für die Auftragsanlage gering sein, um die Zeitverluste beim An- und Abstellen der Anlage oder beim Wechsel einer Beschichtungslösung so gering wie möglich zu halten. Dies ist insbesondere für Anlagen erforderlich, die im Durchlauf oder in Kombination mit anderen Prozeßschritten arbeiten.

Das elektrostatische Sprühverfahren hat diese Vorteile. Bei diesem Verfahren werden Lösungen bzw. Lacke durch ein elektrostatisches Feld zerstäubt und entlang den Feldlinien auf das geerdete, elektrisch leitfähige Werkstück transportiert. Die Zerstäubung kann auch zunächst mechanisch, z. B. durch Druck oder Fliehkraft erfolgen. Dadurch, daß die Lackteilchen geladen sind und das Werkstück geerdet ist, wird - im Gegensatz zu nichtelektrostatischen Sprühverfahren - der größere Teil des Lacks am Substrat niedergeschlagen. Je nach Verfahren sind dies etwa 70-98 %.

Voraussetzung für eine einwandfreie Lackierung ist, daß das Lösemittel von der Tröpfchenoberfläche auf dem Weg zum Werkstück nicht so weit verdampft, daß auf dem Substrat keine einwandfreie Filmbildung mehr möglich ist. Andernfalls erhält man Schichten, die als trockenes Pulver auf dem Substrat liegen oder Oberflächen mit sogenannter Orangenschalenstruktur. Häufig werden auch bereits angetrocknete Lackpartikel als Stippen oder Spritzer auf der nassen Lackschicht abgeschieden.

In der DE-A 17 72 976 ist ein elektrostatisches Sprühverfahren zum Aufbringen von Photoresistlösungen auf Schichtträger für Leiterplatten beschrieben. Das dort beschriebene Verfahren wird bevorzugt rein elektostatisch durchgeführt, d. h. ohne Zuhilfenahme von mechanischen Mitteln, wie Sprühscheiben oder Druckluft, zur Zerstäubung der Lösung. Über die Natur der Photoresistlösung und deren Lösemittel werden dort keine Angaben gemacht.

In der nicht vorveröffentlichten DE-A 35 10 220 ist eine Photoresist-Beschichtungslösung beschrieben, die als Lösemittel einen Monoalkylether des 1,2-Propandiols enthält. Das Aufbringen der Lösung erfolgt in irgendeiner bekannten und üblichen Weise. In einem Beispiel wird die Beschichtung durch elektrostatisches Versprühen beschrieben.

Wendet man elektrostatische Sprühverfahren für die üblichen strahlungsempfindlichen Lösungen, z. B. Photoresistlösungen an, so gelingt es in der Regel nur schwer, homogene Lackschichten im Bereich von wenigen μm zu erhalten. Da für das schonende Trocknen der Naßschichten überwiegend Lösemittel mit hohen Verdampfungsgeschwindigkeiten eingesetzt werden, verflüchtigt sich bereits ein großer Teil der Lösemittel, so daß die Lösung nicht als Flüssigfilm, sondern als Pulver oder angetrocknete Tropfen auf das Werkstück auftrifft. Es entstehen trockene pulvrige oder inhomogene Schichten, die zu keinem glatten Naßfilm mehr verlaufen.

Wünschenswert sind daher Lösemittel für das elektrostatische Sprühverfahren mit strahlungsempfindlichen Lösungen, die glatte homogene Schichten ohne Benetzungsfehler ergeben. Ferner sollen diese Lösemittel ein gutes Lösevermögen für die strahlungsempfindlichen Verbindungen in möglichst hoher Konzentration besitzen und eine Trocknung bei schonenden Temperaturen, d. h. unter 100 °C erlauben. Von Vorteil für die Verarbeitung wäre ferner, wenn die Lösemittel keinen intensiven Geruch besitzen und ihre Handhabung ohne Gesundheitsgefährdung möglich ist. Einige bekannte gute Lösemittel für polare Verbindungen, z. B. Derivate des Ethylenglykols, sind nur in geringen Konzentrationen in der Atemluft am Arbeitsplatz zugelassen, so daß ihr Praxiseinsatz erschwert wird.

Aufgabe der Erfindung war es daher, ein Lösemittel für ein Verfahren zur Herstellung von strahlungsempfindlichen Beschichtungen zu finden, die mit elektrostatischen Sprühverfahren angetragen werden können, das die Ausbildung gleichmäßiger fehlerfreier Schichten und eine Nachtrocknung bei Temperaturen unterhalb 100 °C erlaubt und das ein gutes Lösevermögen für alle gebräuchlichen Bestandteile strahlungsempfindlicher Schichten hat.

Gegenstand der Erfindung ist ein Verfahren zur Herstellung einer strahlungsempfindlichen Resistschicht auf einem Schichtträger bei dem man eine strahlungsempfindliche Beschichtungslösung, die als wesentliche Bestandteile eine strahlungsempfindliche Verbindung, eine strahlungsempfindliche Kombination von Verbindungen oder eine photoleitfähige Verbindung, gelöst in einem organischen Lösemittel oder Lösemittelgemisch enthält, durch elektrostatische Sprühbeschichtung auf den Schichtträger aufbringt und trocknet.

Das erfindungsgemäße Verfahren ist dadurch gekennzeichnet, daß das organische Lösemittel oder Lösemittelgemisch mindestens zum Teil aus 3-Methoxy-butylacetat besteht.

3-Methoxy-butylacetat als Lösemittel ist in einem weiten Bereich für das elektrostatische Sprühen von strahlungsempfindlichen Lösungen anwendbar. Als strahlungsempfindliche Lösungen können vor allem lichtempfindliche Lösungen, insbesondere Positiv- und Negativ-Photoresistlösungen für die Herstellung von Ätz- oder Galvanoreservagen sowie Lötstopresistlösungen, aber auch Lösungen für die Herstellung von Hoch-, Tief- und Flachdruckplatten, Siebdruckschablonen oder elektrophotographische Aufzeichnungsmaterialien eingesetzt werden.

Als elektrostatische Sprühverfahren können Verfahren mit vorwiegend mechanischer Zerstäubung oder mit rein elektrostatischer Zerstäubung eingesetzt werden. Bevorzugt werden mechanisch unterstützte Zerstäubungsverfahren, wie das Hochgeschwindigkeitsrotationsverfahren, da hierbei auch Lösungen mit höherer elektrischer Leitfähigkeit verarbeitet werden können, die z. B. bei der Auflösung stark polarer Verbindungen in polaren Lösemitteln entstehen. Ferner erlauben die mechanisch unterstützten Sprühverfahren einen höheren Mengendurchsatz, was für die Erzielung höherer Schichtdicken oder für höhere Durchlaufgeschwindigkeiten erstrebenswert ist.

Schichten mit 3-Methoxybutylacetat als Lösemittel können nach dem erfindungsgemäßen Verfahren in Bereichen von etwa 1 - 60μm Trockenfilmdicke erzeugt werden. Als zu beschichtende Schichtträger können z. B. kupferkaschierte Isolierstoffplatten für die Herstellung von Leiterplatten, metallisierte Gläser für die Herstellung von Flüssigkristallanzeigeelementen, Keramikmaterialien für Hybridschaltungen, Siliziumscheiben, strukturierte Leiterplatten oder vorbehandelte Aluminiumbleche dienen.

3-Methoxybutylacetat zeigt ein gutes Lösevermögen für die in Photoresists üblicherweise eingesetzten Verbindungen, wie Diazoniumsalze, Chinondiazide, polymerisierbare Monomere, Photoleiter, Bindemittel, Farbstoffe und Lackhilfsmittel. Es ist verträglich mit einer breiten Palette von Lösemitteln und nimmt kein Wasser auf. Der elektrische Widerstand liegt im Bereich der für elektrostatische Sprühverfahren bevorzugten Größenordnung (etwa $10^6$ - $10^8$ Ω cm). Das Lösemittel besitzt einen geringen Eigengeruch. Die Verdampfungsgeschwindigkeit ist so groß, daß die einige μm starken Photoresistschichten bei 80°C getrocknet werden können. Andererseits liegt der Flammpunkt weit über 21°C, was die Handhabung beim Sprühen oder das Versenden der Lösungen erleichtert. Von besonderem Vorteil ist, daß sogar einige handelsübliche Photoresistlösungen, die für Schleuder- oder Walzenantrag konzipiert sind, nach Zusatz von 3-Methoxybutylacetat auch elektrostatisch versprüht werden können.

Das 3-Methoxybutylacetat ist in dem Beschichtungslösemittel bzw. -lösemittelgemisch in einer Menge von 10 bis 100 %, vorzugsweise von 20 bis 80 % enthalten. Die Vorteile des erfindungsgemäßen Verfahrens treten bereits im unteren Teil dieses Mengenbereichs deutlich in Erscheinung. Als weitere Lösemittel können insbesondere Diolmonoalkylether, Alkanole, Alkansäurealkylester, Ketone oder Halogenkohlenwasserstoffe zugesetzt werden. Die Siedepunkte dieser Lösemittel können im Bereich von etwa 50 bis 200 °C, vorzugsweise von 70 bis 180 °C liegen. Mit solchen Lösemitteln kann der Verlauf oder die Verdunstungsgeschwindigkeit der Lösung, das Lösungsvermögen des Lösemittelgemischs oder die Sprödigkeit der abgeschiedenen Schicht in gewünschter Weise beeinflußt werden. Bevorzugte Beispiele sind, neben den in den Ausführungsbeispielen genannten Verbindungen, 2-Ethyl-butanol, 3-Methyl-butanol sowie Methoxy- und Ethoxypropylacetat.

Der Feststoffgehalt der strahlungsempfindlichen Lösungen für die elektrostatische Beschichtung liegt je nach Art der Bindemittel und der erwünschten Schichtdicke zwischen 3 und 35 %, wobei Lösungen mit 5 bis 28 % Feststoff bevorzugt werden.

Der Sprühantrag kann z. B. mittels des Hochgeschwindigkeitsrotationsverfahrens erfolgen, eines mechanischen Sprühverfahrens, bei dem die Tröpfchen durch Zentrifugalkraft an einer mit hohen Umdrehungszahlen rotierenden Glocke erzeugt und anschließend durch das elektrostatische Feld fein zerstäubt werden. Die Glocke liegt dabei an Hochspannung (z. B. 40 - 120 kV). An ihr werden die Tröpfchen aufgeladen, die dann im elektrostatischen Feld zum geerdeten Werkstück wandern. Dabei verlieren sie einen großen Teil des Lösemittels, so daß sie mit Feststoff angereichert auf die Trägeroberfläche auftreffen. Die Lackabscheidungsrate ist mit 85 - 95 % wesentlich höher als z. B. bei druckluftunterstützten elektrostatischen Sprühverfahren.

In der Regel wird das Werkstück vor der rotierenden Sprühglocke vorbeigefahren. Dabei kann sowohl mit einem vertikal aufgehängten Werkstück als auch mit einem horizontal geförderten Werkstück gearbeitet werden. Vorteilhaft bei der vertikalen Aufhängung des Werkstücks ist, daß beide Seiten in einem Arbeitsgang beschichtet und getrocknet werden können, was z. B. für die Herstellung von doppelseitigen Leiterplatten von Interesse ist. Vorteilhaft bei der horizontalen Arbeitsweise ist, daß das Werkstück ohne zusätzliche Kontaktierung auf einem elektrisch leitfähigen Transportband lackiert werden kann.

Im allgemeinen lassen sich Schichtträger mit elektrisch leitfähiger Oberfläche, z. B. Metallplatten oder Isolierstoffplatten mit aufgebrachter Metallschicht, besonders vorteilhaft nach dem erfindungsgemäßen Verfahren beschichten. Es ist aber auch möglich, Werkstücke, deren Oberfläche nur eine geringe elektrische Leitfähigkeit aufweist, elektrostatisch zu beschichten, wenn sie sich auf einer leitfähigen Unterlage, z. B. einem Transportband, oder vor einer geerdeten Gegenelektrode befinden.

Die in dem erfindungsgemäßen Verfahren eingesetzten Beschichtungslösungen enthalten ferner eine strahlungs- bzw. lichtempfindliche Verbindung oder eine strahlungs- bzw. lichtempfindliche Kombination von Verbindungen. Geeignet sind positiv arbeitende Verbindungen, d. h. solche, die durch Belichten löslich werden. Hierzu gehören 1,2-Chinondiazide und Kombinationen von photolytischen Säurespendern und säurespaltbaren Verbindungen, wie Orthocarbonsäure- und Acetalverbindungen.

1,2-Chinondiazide sind bekannt und z. B. in den DE-C 938 233 und 1 543 721, den DE-A 23 31 377, 25 47 905 und 28 28 037 beschrieben. Als 1,2-Chinondiazide werden bevorzugt 1,2-Naphthochinon-2-diazid-4- oder -5-sulfonsäureester oder -amide verwendet. Von diesen werden die Ester, insbesondere die der Sulfonsäuren, besonders bevorzugt. Die Menge an 1,2-Chinondiazidverbindungen beträgt im allgemeinen 3 bis 50, bevorzugt 7 bis 35 Gew.-%, bezogen auf die nichtflüchtigen Anteile des Gemischs.

Auch Beschichtungslösungen auf Basis säurespaltbarer Verbindungen sind bekannt und z.B. in den US-A 3 779 778 und 4 101 323, der DE-C 27 18 254 und den DE-A 28 29 512 und 28 29 511 beschrieben. Sie enthalten als säurespaltbare Verbindungen Orthocarbonsäurederivate, monomere oder polymere Acetale, Enolether oder Acyliminocarbonate. Als strahlungsempfindliche, Säure bildende Verbindungen enthalten sie vorwiegend organische Halogenverbindungen, insbesondere durch Halogenmethylgruppen substituierte s-Triazine oder 2-Trichlormethyl-1,3,4-oxadiazole.

Von den in der US-A 4 101 323 beschriebenen Orthocarbonsäurederivaten werden besonders die Bis-1,3-dioxan-2-yl-ether von aliphatischen Diolen verwendet. Von den in der DE-C 27 18 254 beschriebenen Polyacetalen werden diejenigen mit aliphatischen Aldehyd- und Dioleinheiten bevorzugt.

Weitere gut geeignete Gemische sind in der DE-A 29 28 636 beschrieben. Dort werden als säurespaltbare Verbindungen polymere Orthoester mit wiederkehrenden Orthoestergruppen in der Hauptkette beschrieben. Diese Gruppen sind 2-Alkylether von 1,3-Dioxa-cycloalkanen mit 5 oder 6 Ringgliedern. Besonders bevorzugt werden Polymere mit wiederkehrenden 1,3-Dioxa-cyclohex-2-yl-alkylethereinheiten, in denen die Alkylethergruppe durch Ethersauerstoffatome unterbrochen sein kann und bevorzugt an die 5-Stellung des benachbarten Rings gebunden ist.

Der Mengenanteil der säurespaltbaren Verbindungen in dem lichtempfindlichen Gemisch liegt im allgemeinen zwischen 8 und 65, vorzugsweise zwischen 14 und 44 Gew.-%, bezogen auf die nichtflüchtigen Bestandteile des Gemischs. Die Menge der Säure bildenden Verbindung liegt zwischen 0,1 und 10, vorzugsweise zwischen 0,2 und 5 Gew.-%.

Die in dem erfindungsgemäßen Verfahren verwendeten Beschichtungslösungen können zusätzlich zu den vorstehend beschriebenen lichtempfindlichen Bestandteilen polymere Bindemittel enthalten. Dabei werden solche Polymeren bevorzugt, die wasserunlöslich und in wäßrig-alkalischen Lösungen löslich oder quellbar sind.

Als alkalilösliche bzw. in Alkali quellbare Bindemittel sind natürliche Harze wie Schellack und Kolophonium und synthetische Harze wie Mischpolymerisate aus Styrol und Maleinsäureanhydrid oder Mischpolymerisate der Acrylsäure oder Methacrylsäure, insbesondere mit Acryl- oder Methacrylsäureestern, sowie insbesondere Novolake zu nennen. Als Novolak-Kondensationsharze haben sich besonders die höher kondensierten Harze mit substituierten Phenolen als Formaldehyd-Kondensationspartner bewährt. Die Art und Menge der alkalilöslichen Harze kann je nach Anwendungszweck verschieden sein; bevorzugt sind Anteile am Gesamtfeststoff zwischen 30 und 90, besonders bevorzugt 55 - 85 Gew.-%. Statt oder im Gemisch mit Novolaken sind vorteilhaft auch Phenolharze vom Typ des Poly(4-vinyl-phenols) verwendbar. Zusätzlich können noch zahlreiche andere Harze mitverwendet werden, bevorzugt Vinylpolymerisate wie Polyvinylacetate, Polyacrylate, Polyvinylether und Polyvinylpyrrolidone, die selbst durch Comonomere modifiziert sein können. Der günstigste Anteil an diesen Harzen richtet sich nach den anwendungstechnischen Erfordernissen und dem Einfluß auf die Entwicklungsbedingungen und beträgt im allgemeinen nicht mehr als 20% vom alkalilöslichen Harz. In geringen Mengen kann das lichtempfindliche Gemisch für spezielle Erfordernisse wie Flexibilität, Haftung und Glanz etc. außerdem noch Substanzen wie Polyglykole, Cellulosederivate wie Ethylcellulose, Netzmittel, Farbstoffe und feinteilige Pigmente sowie bei Bedarf UV-Absorber enthalten.

Als lichtempfindliche Kombinationen sind auch photopolymerisierbare Gemische geeignet. Diese enthalten als wesentliche Bestandteile eine polymerisierbare Verbindung mit mindestens zwei endständigen ethylenisch ungesättigten Doppelbindungen, ein polymeres Bindemittel und einen Photoinitiator, der unter Einwirkung von aktinischer Strahlung die radikalische Polymerisation der ethylenisch ungesättigten Verbindung einzuleiten vermag. Als weitere Bestandteile kann die Schicht Stabilisatoren bzw. Inhibitoren zur Verhinderung der Dunkelpolymerisation der Monomeren, Wasserstoffdonatoren, Netzmittel, Weichmacher, sensitometrische Regler, Farbstoffe und farblose oder Farbpigmente enthalten.

Die Photoinitiatoren werden im allgemeinen in einer Menge von 0,01 bis 10, bevorzugt von 0,2 bis 5 Gew.-%, bezogen auf die Bestandteile der photopolymerisierbaren Schicht, zugesetzt.

Für die Zwecke der Erfindung geeignete photopolymerisierbare Monomere sind bekannt und z. B. in den US-A 2 760 863 und 3 060 023 beschrieben.

Bevorzugte Beispiele sind Acryl- und Methacrylsäureester, wie Polyethylenglykoldimethacrylat, Acrylate und Methacrylate von Trimethylolethan, Trimethylolpropan und Pentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A 20 64 079 und 23 61 041 beschrieben.

Der Mengenanteil der Schicht an Monomeren beträgt im allgemeinen etwa 10 bis 80, vorzugsweise 20 bis 60 Gew.-%.

Als Bindemittel werden vorzugsweise solche verwendet, die in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: -COOH, $-PO_3H_2$, $-SO_3H$, $-SO_2NH_2$, $-SO_2$-NH-CO- und dgl.. Als Beispiele hierfür seien genannt: Maleinatharze, Polymerisate aus N-(p-Tolyl-sulfonyl)-carbaminsäure-(ß-methacryloyloxy-ethyl)ester und Mischpolymerisate dieser und ähnlicher Monomerer mit anderen Monomeren sowie Styrol-Maleinsäureanhydrid-Mischpolymerisate. Methylmethacrylat-Methacrylsäure-Mischpolymerisate und Mischpolymerisate aus Methacrylsäure, Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 40 bis 80 Gew.-% der Bestandteile der Schicht.

Lichtempfindliche Gemische auf Basis von Diazoniumsalz-Polykondensationsprodukten können ebenfalls verwendet werden.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenoläthern, aromatischen Thioäthern, aromatischen Kohlenwasserstoffen, aromatischen Heterocyclen und organischen Säureamiden, abgeleitet sind. Diese Kondensationsprodukte sind in der US-A 3 867 147 beschrieben. Allgemein sind alle Diazoniumsalz-Polykondensationsprodukte geeignet, die in der US-A 4 186 017 beschrieben sind.

Die lichtempfindlichen Gemische können außerdem Bindemittel, Farbstoffe, Indikatoren, Pigmente, Stabilisatoren, Netzmittel und weitere übliche Zusätze enthalten. Die Bindemittel können wasserlöslich oder wasserunlöslich sein. Mit Vorteil werden wasserunlösliche harzartige Bindemittel, insbesondere in Kombination mit den bevorzugten Mischkondensationsprodukten von Diazoniumsalzen, verwendet. Beispiele für geeignete Bindemittel sind Polyalkylacrylate, Methacrylsäure-Alkylmethacrylat-Mischpolymerisate, Polymere mit seitenständigen Sulfonylurethangruppen, Phenolharze, Harnstoffharze, Melaminharze, Epoxyharze, Polyurethane, Polyvinylester und Polyvinylacetale.

Der Mengenanteil an Diazoniumsalz-Polykondensationsprodukt liegt im allgemeinen bei 10 bis 100, bevorzugt 20 bis 95 Gew.-%, die Menge des Bindemittels beträgt 0 bis 90, vorzugsweise 5 bis 80 Gew.-% der gesamten Schicht.

Es können auch photoleitfähige Schichten nach dem erfindungsgemäßen Verfahren aufgebracht werden. Das gilt sowohl für Einfachschichten wie für Doppelschichten aus Ladungsträger- und Transportschichten. Geeignete Schichtzusammensetzungen sind z. B. in den DE-C 11 17 391, 15 22 497, 15 72 312, 23 22 046 und 23 22 047 beschrieben.

Durch das erfindungsgemäße Verfahren werden auch bei geringer Schichtdicke sehr gleichmäßige fehlerfreie Beschichtungen erhalten. Mit anderen Lösemitteln ähnlicher Struktur, wie Glykolhalbethern oder -estern werden diese Vorteile nicht erreicht.

Die folgenden Beispiele erläutern bevorzugte Ausführungsformen des erfindungsgemäßen Verfahrens. Mengenverhältnisse und Prozentangaben sind, wenn nichts anderes angegeben ist, in Gewichtseinheiten zu verstehen. Gewichtsteile (Gt) und Volumteile (Vt) stehen im Verhältnis von g zu ml.

Beispiel 1

Eine Lösung von
8,3 Gt eines Kresol-Formaldehyd-Novolaks mit dem Erweichungsbereich 105 - 120 ° C nach DIN 53181,
7,0 Gt einer 50 %igen Lösung von Polyvinylmethylether in Toluol und
2,0 Gt 1,2-Naphthochinon-2-diazid-4-sulfonsäureester des 4-(2-Phenylprop-2-yl)-phenols in
82 Gt 3-Methoxy-butylacetat

wurde zur Herstellung von Leiterplatten auf ein Basismaterial, bestehend aus 35 $\mu$m Kupfer/50 $\mu$m Glasfaser-Epoxyharz/35$\mu$m Kupfer, wie folgt aufgebracht:

An einer Hochgeschwindigkeitsrotationsglocke (60 mm Durchmesser) wurde die Lösung bei ca. 20.000 U/min und 100 kV Gleichspannung versprüht. Das geerdete Basismaterial wurde mit 1 m/min Vorschub im Abstand von 25 cm an der Sprühglocke vorbeitransportiert. Die Schichtdicke wurde durch die Leistung der Dosierpumpe geregelt und so eingestellt, daß man nach Trocknen eine ca. 5 $\mu$m dicke Resistschicht erhielt. In diesem Bereich erwies sich die Schicht beim anschließenden Ätzen als resistent.

Nach 10 Minuten Trocknen bei 80 ° C wurde eine glatte, glänzende strahlungsempfindliche Schicht erhalten, die, wie für die Herstellung von Leiterplatten üblich, belichtet und mit einer Lösung von

0,5 % NaOH und
0,8 % Natriummetasilikat × 9 Wasser in
1,0 % 2-Butoxy-ethanol und
97,7 % vollentsalztem Wasser

entwickelt wurde. Beim Ätzen des Kupfers traten keine Pin-holes in den lackierten Flächen auf.

Beispiel 2

Durch Auflösen von
14 Gt eines Novolaks wie in Beispiel 1,
1,8 Gt Polyvinylmethylether (® Lutonal A 25),
4,1 Gt des Polyacetals aus 2-Ethylbutyraldehyd und Triethylenglykol und
0,1 Gt 2-(6-Methoxy-naphth-2-yl)-4,6-bis-trichlormethyl-s-triazin in
35 Gt 1-Methoxy-propan-2-ol und
55 Gt 3-Methoxy-butylacetat

wurde eine strahlungsempfindliche Resistlösung mit 18 % Feststoffgehalt hergestellt. Durch elektrostatische Sprühbeschichtung wurde auf eine im Abstand von 25 cm befindliche, mit Indium-Zinn-Oxid beschichtete Glasscheibe eine ca. 6 $\mu$m dicke Schicht aufgebracht. Nach 12 Minuten Trocknen bei 80 ° C wurde unter einer positiven Vorlage für die Herstellung von Flüssigkristallanzeigeelementen (LCD) belichtet. Nach Entwicklung mit der in Beispiel 1 angegebenen Entwicklerlösung wurde das freigelegte Indium-Zinn-Oxid durch 5 %ige Salzsäure weggeätzt.

In einem zweiten Versuch wurde eine 18 %ige Lösung der gleichen Bestandteile in 1-Methoxy-propan-2-ol ohne Zusatz von 3-Methoxy-butylacetat angesetzt. Beim elektrostatischen Sprühen unter gleichen Versuchsbedingungen schieden sich angetrocknete Lackteile als klebrige Masse auf der Indium-Zinn-Oxid-Oberfläche ab. Es konnte kein homogener Lackfilm erhalten werden.

Beispiel 3

Zur Herstellung integrierter Schaltkreise auf Siliziumscheiben wurde eine Resistlösung wie folgt hergestellt: In

| 53 Gt | 3-Methoxy-butylacetat und |
| 40 Gt | 1-Methoxy-propan-2-ol wurden |
| 6 Gt | Novolak entsprechend Beispiel 1 und |
| 1 Gt | eines Estergemisches, erhalten aus 1 mol 2,3,4-Trihydroxybenzophenon und 2 mol 1,2-Naphthochinon-2-diazid-5-sulfonsäurechlorid |

gelöst. Die Siliziumscheibe wurde auf einen metallischen, geerdeten Transportschlitten gelegt und mit 2,3 m/min Vorschub unter einer senkrecht installierten Sprühglocke (Ø42 mm) im Abstand von 17 cm vorbeigefahren. Die Hochspannung war auf 70 kV eingestellt. Die Umdrehungsgeschwindigkeit der Sprühglocke betrug ca. 15.000 U/min. Die Pumpendrehzahl wurde so eingestellt, daß nach dem Trocknen eine Schichtdicke von 2,0 g/m$^2$ entstand. Nach Durchlauf unter der Sprühglocke wurde die lackierte Scheibe in einem Trockenofen bei 80 °C 3 Minuten erwärmt und weitere 5 Minuten unter einem Infrarot-Strahler im Abstand von 5 cm getempert. Die Lackschicht zeigte keine Orangenschalenstruktur. Nach Belichten und Entwickeln konnten Strukturzüge wie in der Mikroelektronik üblich durch Ätzen aufgebracht werden.

Beispiel 4

Zur Fertigung beidseitig strukturierter und durchkontaktierter Leiterplatten wurde die folgende Lösung eines Negativ-Flüssigresists hergestellt:

| 12,0 Gt | eines Terpolymeren aus 60 % n-Hexylmethacrylat, 30 % Methacrylsäure und 10 % Styrol mit einem mittleren Molekulargewicht von 33.000 und der Säurezahl 200, |
| 6,0 Gt | Polypropylenglykoldimethacrylat, |
| 0,6 Gt | 9-Phenyl-acridin, |
| 0,05 Gt | eines blauen Azofarbstoffs, erhalten durch Kuppeln von 2,4-Dinitro-6-chlor-benzol-diazoniumsalz mit 2-Methoxy-5-acetylamino-N,N-diethylanilin, |
| 60,0 Gt | 3-Methoxy-butylacetat und |
| 22,0 Gt | Butanon. |

Eine beidseitig kupferlaminierte, durchbohrte und durchkontaktierte Leiterplatte von 200 × 310 mm Größe und 1,5 mm Dicke wurde zwischen zwei Metallrahmen mit dem Innenmaß 196 × 306 mm gelegt, die durch Klammern zusammengehalten wurden. Der Metallrahmen wurde an einem Fördersystem so aufgehängt, daß er um eine in seiner Ebene liegende Achse rotieren konnte, und geerdet. Mittels eines Antriebssystems wurde der Rahmen in Rotation gesetzt, so daß auf einer Förderstrecke von 16 cm die Leiterplatte eine volle Umdrehung ausführte. Der Sprühkopf war im Abstand von 27 cm vom Mittelpunkt des Werkstücks horizontal installiert und oszillierte mit 5 Doppelhüben pro Minute um eine Auslenkung von 20 cm. Das Werkstück wurde mit einer Geschwindigkeit von 1,5 m/min unter Rotieren vor dem oszillierenden Sprühkopf vorbeigeführt. Bei einer Spannung von 60 kV wurde die Dosiermenge so eingestellt, daß auf jede Seite der Leiterplatte eine Resistschicht von 6,5 g/m$^2$ Trockengewicht aufgebracht wurde. Die Trocknung erfolgte hängend in einem Umluftofen bei 75 °C innerhalb von 9 Minuten.

Nach dem Trocknen wurde die Leiterplatte aus dem Metallrahmen genommen. Die Messung der Reststärke ergab, daß die Schichtdicken auf der Vorder- und Rückseite weniger als ± 10 % voneinander abwichen. Die Resistschicht wurde unter einer negativen Leiterbahnvorlage im Vakuum belichtet und anschließend durch Besprühen mit 0,8 %iger Natriumcarbonatlösung entwickelt. Dabei wurden die an den Kanten der Durchkontaktierungsbohrungen aufgesprühten Lackpartikel entfernt, so daß die verkupferten Bohrlöcher frei lagen.

Beispiel 5

Für die Herstellung einer Offsetdruckform durch elektrostatische Sprühbeschichtung wurde folgende Beschichtungslösung eingesetzt:

| 75 Gt | Novolak wie in Beispiel 1, |
| 22 Gt | eines Estergemisches, erhalten durch Umsetzen von 1 mol 2,3,4-Trihydroxybenzophenon mit 1 mol 1,2-Naphthochinon-2-diazid-5-sulfonsäurechlorid, |
| 2 Gt | 1,2-Naphthochinon-2-diazid-4-sulfonsäurechlorid und |
| 1 Gt | Kristallviolett in |
| 550 Gt | 3-Methoxy-butylacetat, |
| 400 Gt | 1-Methoxy-propan-2-ol und |
| 50 Gt | 2-Ethyl-hexanol |

Diese Lösung wurde auf eine elektrochemisch aufgerauhte und anodisierte Aluminiumplatte der Stärke 0,3 mm durch elektrostatische Sprühbeschichtung aufgebracht. Die Sprühglocke war im Abstand von 25 cm senkrecht über einem geerdeten Transportsystem installiert, auf dem die Platte horizontal mit einer Geschwindigkeit von 2,0 m/min an der Glocke vorbeigeführt wurde. Die Lösung wurde mittels einer Dosierpumpe bei einer Hochspannung von 90 kV so aufgebracht, daß ein Trockengewicht von 2,2 g/m$^2$ erhalten wurde. Beim Sprühen wurde ein homogener, glänzender Naßfilm erhalten, der nach 8 Minuten Trocknen bei 85 °C einen matten Film ergab.

Die Druckplatte wurde unter einer positiven Vorlage belichtet, mit einer 3,5 %igen Lösung von Trinatriumphosphat, die durch Zugabe von Natriumhydroxid auf einen pH-Wert von 12,6 eingestellt war, entwickelt, mit Wasser abgespült und mit 1 %iger Phosphorsäure druckfertig eingestellt.

### Beispiel 6

Das folgende Beispiel soll den positiven Einfluß von 3-Methoxy-butylacetat beim elektrostatischen Sprühen lichtempfindlicher Lösungen belegen, die sich ohne dieses Lösemittel elektrostatisch nicht versprühen lassen.

Eine Lösung von

| | |
|---|---|
| 3,3 Gt | des in Beispiel 5 angegebenen Estergemischs, |
| 15,7 Gt | Novolak wie in Beispiel 1 und |
| 1 Gt | Vinylacetat/Crotonsäure-Mischpolymerisat (95:5) in |
| 56 Gt | 1,1,1-Trichlorethan, |
| 19 Gt | Isopropanol und |
| 5 Gt | Butylacetat |

wurde an einer Hochrotationsglocke (42 mm Ø) im Abstand von 20 cm auf ein Kupferblech gesprüht. Die Lösung schied sich als klebriges Pulver und in groben Spritzern auf dem Substrat ab. Es war kein zusammenhängender Lackfilm zu erhalten.

In einem zweiten Versuch wurde die folgende Sprühlösung hergestellt:

| | |
|---|---|
| 3,3 Gt | des oben angegebenen Estergemischs, |
| 15,7 Gt | Novolak wie in Beispiel 1 und |
| 1 Gt | des oben angegebenen Mischpolymerisats in |
| 33 Gt | 1,1,1-Trichlorethan, |
| 11 Gt | Isopropanol, |
| 3 Gt | Butylacetat, |
| 30 Gt | 3-Methoxy-butylacetat und |
| 3 Gt | 3-Methoxy-butanol. |

Diese Lösung wurde unter gleichen Bedingungen wie oben auf ein Kupferblech gesprüht. Die Lösung schied sich als homogener Naßfilm ab, der nach dem Trocknen (5 Minuten bei 80 °C) einen glänzenden, glatten, homogenen Film einer Dicke von 8 g/m$^2$ ergab.

### Beispiel 7

Zur Herstellung eines elektrophotographischen Aufzeichnungsmaterials wurde wie folgt verfahren. Eine Lösung von

| | |
|---|---|
| 3,6 Gt | 2,5-Bis-(4-diethylamino-phenyl)-oxadiazol, |
| 4,4 Gt | eines Styrol-Maleinsäureanhydrid-Mischpolymerisats (Säurezahl 180) und |
| 0,1 Gt | Rhodamin B (C.I. 45170) in |
| 58,0 Gt | Butylacetat, |
| 9,0 Gt | n-Butanol, |
| 8,3 Gt | Tetrahydrofuran, |
| 8,3 Gt | 2-Ethoxy-ethylacetat und |
| 8,3 Gt | Xylol |

wurde durch elektrostatische Sprühbeschichtung mittels Hochrotationsglocke auf ein aluminiumbedampftes Folienband aus Polyethylenterephthalat aufgebracht. Die Aluminiumschicht war geerdet. Der Sprühabstand betrug 27 cm, der Bandvorschub 2 m/Minute. Nach 5 Minuten Trocknen in einem Wärmeofen bei 100 °C verblieb eine 4-5 μm dicke Schicht, die eine deutliche Orangenschalenstruktur hatte und weißliche Stippen aufwies. Der Glockenrand war mit angetrockneten Lackresten belegt, die beim Sprühen auf die Naßschicht gerieten.

In einem weiteren Versuch wurde eine Lösung der gleichen Mengen der gleichen Bestandteile in dem folgenden Lösemittelgemisch hergestellt:

| | |
|---|---|
| 45,8 Gt | n-Butylacetat, |
| 7,1 Gt | Butanol, |
| 6,6 Gt | Tetrahydrofuran, |
| 6,6 Gt | 2-Ethoxy-ethylacetat, |
| 6,6 Gt | Xylol und |
| 21,0 Gt | 3-Methoxy-butylacetat. |

Durch Versprühen und Trocknen unter den gleichen Bedingungen wie oben wurde eine 4-5 μm dicke glänzende Lackschicht ohne Stippen erhalten. Nach Aufladen unter einer Corona wies die Schicht eine Dunkelaufladung von -345 V und eine Lichtempfindlichkeit (E 1/2) von 22 μJ/cm$^2$ auf.

### Beispiel 8

Eine Lösung von

| | |
|---|---|
| 2,0 Gt | eines Polykondensationsprodukts aus 1 mol 3-Methoxy-diphenylamin-4-diazoniumsulfat, 1 mol 4-Methoxymethyl-4'-methyl-diphenylether und 1 mol 4,4'-Bis-methoxymethyl-diphenylether, hergestellt in 85 %iger Phosphorsäure und ausgefällt als Mesitylensulfonat, |
| 0,17 Gt | Phosphorsäure (85 %) und |
| 0,034 Gt | 4-Phenylazo-diphenylamin in |
| 30 Gt | 2-Methoxy-ethanol, |
| 50 Gt | 3-Methoxy-butanol und |
| 20 Gt | 3-Methoxy-butylacetat |

wurde elektrostatisch auf eine elektrolytisch aufgerauhte und anodisierte Aluminiumplatte von 0,27 mm Dicke aufgesprüht. Nach dem Trocknen wurde eine sehr homogene lichtempfindliche Schicht mit einem Flächengewicht von 0,3-0,4 g/m$^2$ erhalten. Durch Belichten und Entwickeln mit einer Lösung von

| 5,0 Gt | Natriumundecanoat, |
|---|---|
| 3 Gt | eines Block-Mischpolymerisats aus 80 % Propylenoxid und 20 % Ethylenoxid und |
| 3 Gt | Tetranatriumdiphosphat in |
| 89 Gt | Wasser |

wurde daraus eine Flachdruckform erhalten.

Gleiche Ergebnisse wurden erhalten, wenn eine Sprühlösung verwendet wurde, die anstelle des oben angegebenen Kondensationsprodukts ein Polykondensationsprodukt aus 1 mol 3-Methoxy-diphenylamin und 1 mol 4,4'-Bis-methoxy-methyldiphenylether enthielt.

## Patentansprüche

1. Verfahren zur Herstellung einer strahlungsempfindlichen Resistschicht auf einem Schichtträger bei dem man eine strahlungsempfindliche Beschichtungslösung, die als wesentliche Bestandteile eine strahlungsempfindliche Verbindung, eine strahlungsempfindliche Kombination von Verbindungen oder eine photoleitfähige Verbindung, gelöst in einem organischen Lösemittel oder Lösemittelgemisch enthält, durch elektrostatische Sprühbeschichtung auf den Schichtträger aufbringt und trocknet, dadurch gekennzeichnet, daß das organische Lösemittel oder Lösemittelgemisch mindestens zum Teil aus 3-Methoxy-butylacetat besteht.

2. Verfahren nach Anspruch 1, dadurch gekennzeichnet, daß die strahlungsempfindliche Beschichtungslösung ferner ein polymeres Bindemittel enthält.

3. Verfahren nach Anspruch 1, dadurch gekennzeichnet, daß die strahlungsempfindliche Beschichtungslösung als strahlungsempfindliche Verbindung ein 1,2-Naphthochinondiazid enthält.

4. Verfahren nach Anspruch 1, dadurch gekennzeichnet, daß die strahlungsempfindliche Beschichtungslösung als strahlungsempfindliche Kombination von Verbindungen
   a) eine Verbindung mit mindestens einer durch Säure spaltbaren C-O-C-Bindung und
   b) eine bei Bestrahlung eine starke Säure bildende Verbindung enthält.

5. Verfahren nach Anspruch 1, dadurch gekennzeichnet, daß die strahlungsempfindliche Beschichtungslösung ein photopolymerisierbares Gemisch aus einem polymeren Bindemittel, einer radikalisch polymerisierbaren Verbindung mit mindestens zwei endständigen ethylenisch ungesättigten Gruppen und einem Siedepunkt unter Normaldruck von mindestens 100°C sowie einen bei Bestrahlung Radikale bildenden Polymerisationsinitiator enthält.

6. Verfahren nach Anspruch 1, dadurch gekennzeichnet, daß die strahlungsempfindliche Beschichtungslösung als strahlungsempfindliche Verbindung ein Diazoniumsalz-Polykondensationsprodukt enthält.

7. Verfahren nach Anspruch 1, dadurch gekennzeichnet, daß das Lösemittel bzw.Lösemittelgemisch zu 10 bis 100% aus 3-Methoxy-butylacetat besteht.

8. Verfahren nach Anspruch 7, dadurch gekennzeichnet, daß das Lösemittelgemisch als weiteres Lösemittel einen Diolmonoalkylether, ein Alkanol, einen Alkylester einer Alkansäure, ein Keton oder einen Halogenkohlenwasserstoff enthält.

9. Verfahren nach einem oder mehreren der Ansprüche 1 bis 8, dadurch gekennzeichnet, daß das Versprühen der Beschichtungslösung mit mechanischen Mitteln unterstützt wird.

10. Verfahren nach einem oder mehreren der Anspüche 1 bis 9, dadurch gekennzeichnet, daß der Schichtträger eine elektrisch leitfähige Oberfläche hat.

11. Verfahren nach einem oder mehreren der Ansprüche 1 bis 10, dadurch gekennzeichnet, daß man eine Lösung mit 3 bis 30 Gew.-% Feststoffgehalt einsetzt.

## Claims

1. Process for the production of a radiation-sensitive resist layer on a layer support, in which a radiation-sensitive coating solution containing, as the essential constituents, a radiation-sensitive compound, a radiation-sensitive combination of compounds or a photoconductive compound, dissolved in an organic solvent or solvent mixture, is applied to the layer support by electrostatic spray coating and dried, wherein the organic solvent or solvent mixture is at least partially composed of 3-methoxybutyl acetate.

2. The process as claimed in claim 1, wherein the radiation-sensitive coating solution further contains a polymeric binder.

3. The process as claimed in claim 1, wherein the radiation-sensitive coating solution contains, as the radiation-sensitive compound, a 1,2-naphthoquinone diazide.

4. The process as claimed in claim 1, wherein the radiation-sensitive coating solution contains, as the radiation-sensitive combination of compounds,
   a) a compound having at least one acid-cleavable C-O-C bond and
   b) a compound which forms a strong acid upon irradiation.

5. The process as claimed in claim 1, wherein the radiation-sensitive coating solution contains a photopolymerizable composition comprising a polymeric binder, a free-radically polymerizable compound having at least two ethylenically unsaturated end groups and a boiling point under normal pressure of at least 100 °C, and a polymerization initiator which forms free radicals upon irradiation.

6. The process as claimed in claim 1, wherein the radiation-sensitive coating solution contains, as the radiation-sensitive compound, a diazonium salt polycondensation product.

7. The process as claimed in claim 1, wherein the solvent or solvent mixture comprises from 10 to 100 % of 3-methoxybutyl acetate.

8. The process as claimed in claim 7, wherein the solvent mixture contains, as a further solvent, a diolmonoalkyl ether, an alkanol, an alkyl ester of an alkanoic acid, a ketone or a halogenated hydrocarbon.

9. The process as claimed in any one or several of claims 1 to 8, wherein spraying of the coating solution is assisted by mechanical means.

10. The process as claimed in any one or several of claims 1 to 9, wherein the layer support has an electrically conductive surface.

11. The process as claimed in any one or several of claims 1 to 10, wherein the solution used has a solids content from 3 to 30 % by weight.

**Revendications**

1. Procédé de fabrication d'une couche de résist radiosensible sur un support de couche, dans lequel on dépose sur le support de couche une solution d'enduction radiosensible qui contient, comme constituants essentiels, un composé radiosensible, une combinaison radiosensible de composés ou un composé photoconducteur, dissous dans un solvant organique ou un mélange de solvants organiques, par enduction par pulvérisation électrostatique, puis on sèche, procédé caractérisé en ce que le solvant organique ou le mélange de solvants organiques se compose au moins partiellement d'acétate de 3-méthoxybutyle.

2. Procédé selon la revendication 1, caractérisé en ce que la solution d'enduction radiosensible contient en outre un liant polymère.

3. Procédé selon la revendication 1, caractérisé en ce que la solution d'enduction radiosensible contient, comme composé radiosensible, un 1,2-naphtoquinonediazide.

4. Procédé selon la revendication 1, caractérisé en ce que la solution d'enduction radiosensible contient, comme combinaison radiosensible de composés,
   a) un composé avec au moins une liaison C-O-C clivable par un acide et
   b) un composé générateur d'acide fort, sous l'effet d'une irradiation.

5. Procédé selon la revendication 1, caractérisé en ce que la solution d'enduction radiosensible contient un mélange photopolymérisable constitué d'un liant polymère, d'un composé polymérisable par radicaux libres comportant au moins deux groupes terminaux à insaturation éthylénique et ayant un point d'ébullition sous pression normale d'au moins 100°C, ainsi qu'un amorceur de polymérisation générateur de radicaux par irradiation.

6. Procédé selon la revendication 1, caractérisé en ce que la solution d'enduction radiosensible contient, comme composé radiosensible, un produit de polycondensation d'un sel de diazonium.

7. Procédé selon la revendication 1, caractérisé en ce que le solvant organique ou le mélange de solvants organiques se compose d'acétate de 3-méthoxybutyle à raison de 10 à 100 %.

8. Procédé selon la revendication 7, caractérisé en ce que le mélange de solvants organiques contient, comme solvant supplémentaire, un éther monoalkylique de diol, un alcanol, un ester alkylique d'un acide alcanoïque, une cétone ou un hydrocarbure halogéné.

9. Procédé selon une ou plusieurs des revendications 1 à 8, caractérisé en ce que la pulvérisation de la solution d'enduction est assistée des moyens mécaniques.

10. Procédé selon une ou plusieurs des revendications 1 a 9, caractérisé en ce que le support de couche possède une surface conductrice de l'électricité.

11. Procédé selon une ou plusieurs des revendications 1 à 10, caractérisé en ce qu'on utilise une solution dont la teneur en solides vaut de 3 à 30 % en poids.